# EUROPÄISCHE PATENTANMELDUNG

(11) **EP 4 525 569 A1**
(43) Veröffentlichungstag der Anmeldung: **19.03.2025**
(21) Anmeldenummer: 24192085.9
(22) Anmeldetag: 31.07.2024
(51) Int. Cl.: H05K 5/02, H05K 7/20

(54) **SCHALTGERÄT**

(30) Priorität: 18.09.2023 DE 102023209036
(71) Anmelder: Siemens Aktiengesellschaft, 80333 München (DE)
(72) Erfinder: Eisner, Matthias, 92259 Neukirchen (DE)
(74) Vertreter: Siemens Patent Attorneys

(57) **Zusammenfassung**

Die Erfindung betrifft ein Schaltgerät (10), aufweisend
- ein Gehäuse (2) mit einer Frontwand (20), einer Rückwand (22), einer Deckenwand (24) und einer Bodenwand (26), und zwei Seitenwänden (28L, 28R), wobei in dem Gehäuse (2) ein parallel zu den Seitenwänden (28L, 28R) verlaufender Luftkanal (4) ausgebildet ist, der eine lichte Breite D aufweist,
- eine Drehwelle (6), die sich von der Frontwand (20) zu der Rückwand (22) erstreckt und mit einem ersten Endabschnitt (6F) in der Frontwand (20) und mit einem zweiten Endabschnitt (6R) in der Rückwand (22) drehbar gelagert ist, wobei die Drehwelle (6) am Ende ihres ersten Endabschnitts (6F) eine drehfest mit der Drehwelle (6) verbundene Drehvorrichtung (62) trägt, die an der Außenseite der Frontwand (20) zugänglich ist, und wobei die Drehwelle (6) am Ende ihres zweiten Endabschnitts (6R) eine drehfest mit der Drehwelle verbundene Kupplungsvorrichtung (64) trägt, mithilfe der das Schaltgerät an einer korrespondierenden Aufnahmevorrichtung (BU) befestigbar ist,
- wobei die Bodenwand (26) und die Deckenwand (24) jeweils mindestens eine Lüftungsöffnung (26.1, 24.1) aufweisen, so dass in dem Luftkanal (4) ein Luftstrom (A) von der Lüftungsöffnung (26.1) der Bodenwand (26) zu der Lüftungsöffnung (24.1) der Deckenwand (24) strömen kann,
- wobei die Drehwelle (6) einen zwischen dem ersten (6F) und dem zweiten (6R) Endabschnitt liegenden mittleren Abschnitt (6M) mit einem Außendurchmesser d aufweist, der im Luftkanal (4) liegt und
dadurch gekennzeichnet,
dass die Drehwelle als eine Hohlwelle ausgebildet ist und das Verhältnis D/d größer als 1,5 ist.

## Beschreibung

Die vorliegende Erfindung betrifft ein Schaltgerät sowie ein Verfahren zur Herstellung einer Drehwelle für ein Schaltgerät.

Ein SIMATIC ET 200SP Motorstarter der Siemens AG, d. h. ein Schaltgerät zum Starten und Stoppen eines Motors, wird auf eine korrespondierende, vollverdrahtete Montagebasis ("Base-Unit") montiert, indem zunächst eine mechanische Drehverriegelung des Motorstarters in eine Montage-/Demontageposition gebracht wird (Fig. 1), dann der Motorstarter auf die Montagebasis geführt wird (Fig. 1) und schließlich die Drehverriegelung im Uhrzeigersinn in die Betriebsposition gedreht wird (Fig. 2 und 3), in welcher der Motorstarter fest in der Montagebasis verriegelt ist und alle elektrischen Kontakte verbunden sind, siehe Kapitel 6.14.2 "Motorstarter montieren / demontieren" in: Systemhandbuch "SIMATIC ET 200SP Dezentrales Peripheriesystem", Ausgabe 02/2018 (Februar 2018), A5E03576848-AH, Siemens AG, Division Digital Factory, Nürnberg, Deutschland.

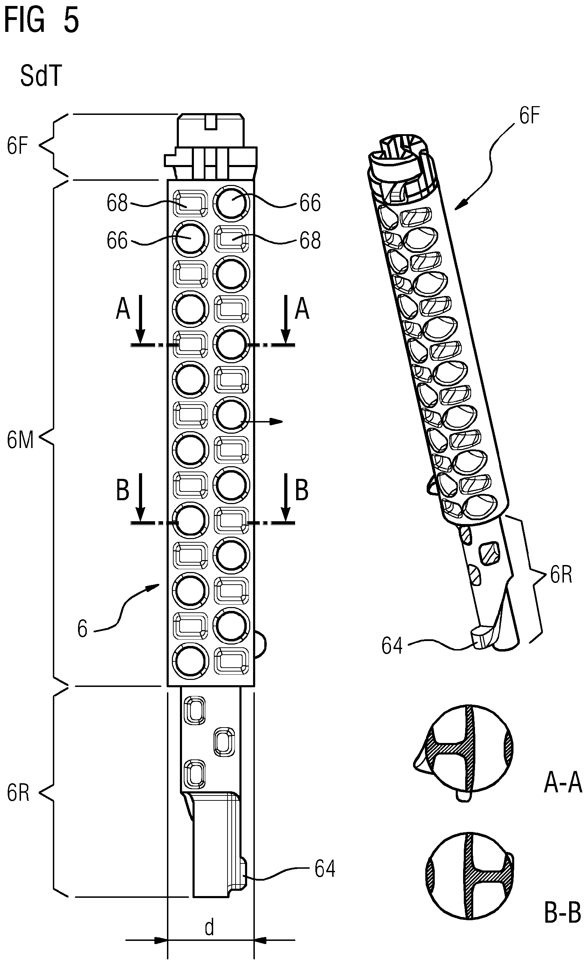

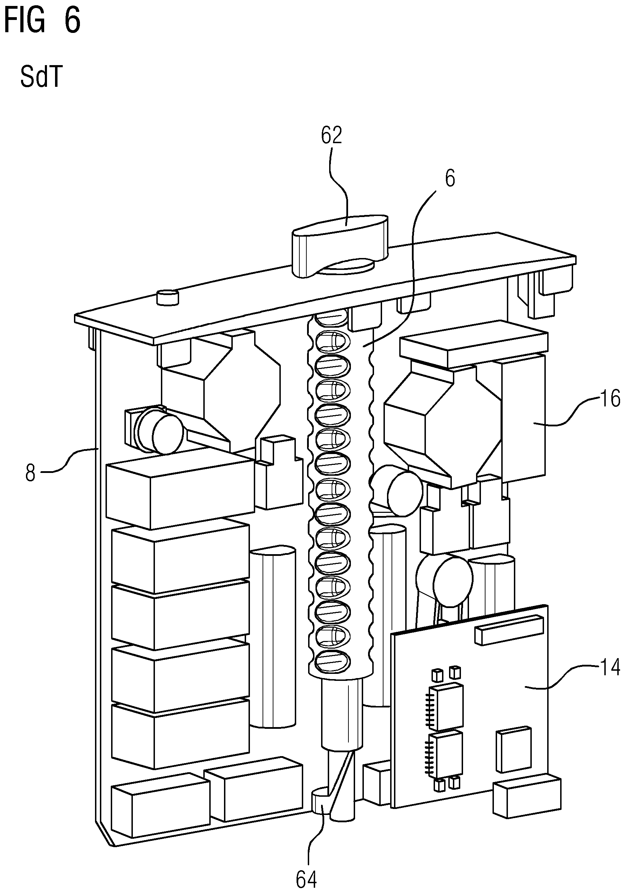

Dabei ist die mechanische Drehverriegelung als eine Vollwelle aus Kunststoff ausgebildet (Fig. 5). Die Vollwelle ist jeweils in einer Frontwand und in einer Rückwand des Motorstarter-Gehäuses gelagert, trägt an ihrem aus der Frontwand herausragenden einen Ende einen Knebel zur Handbetätigung und weist an ihrem aus der Rückwand herausragenden anderen Ende eine Haltenase auf, die in eine korrespondierende Nutenbahn in der Montagebasis einrasten kann, in der Art eines Bajonettverschlusses (Fig. 6). Dabei weist die Vollwelle einen relativ großen Durchmesser auf, um die nötige Verdrehsteifigkeit zu gewährleisten: Bei der Betätigung des Knebels können Drehmomente von zeitweise bis zu 2 Nm auftreten.

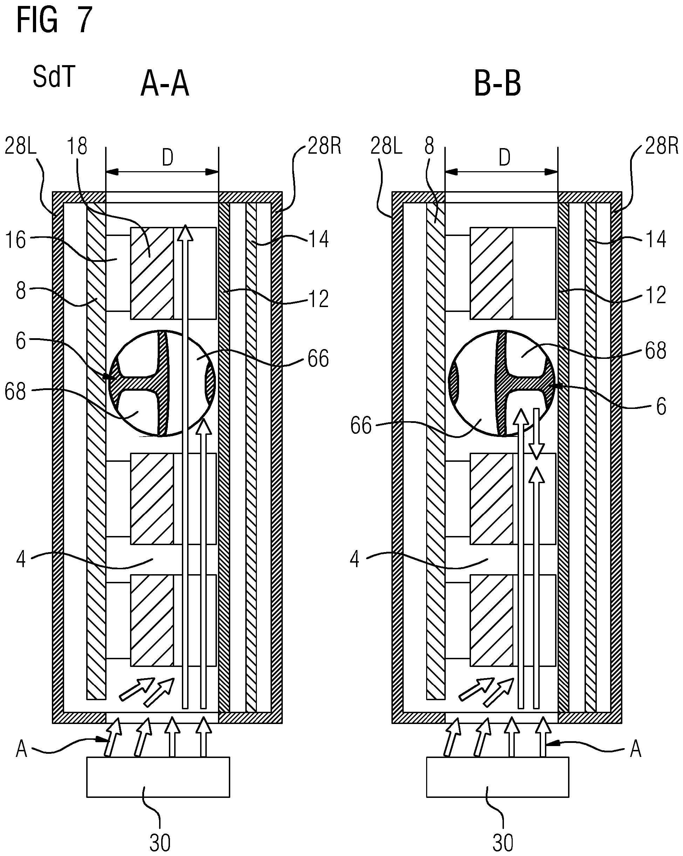

Aufgrund ihres großen Durchmessers behindert die Vollwelle allerdings eine Durchströmung des Motorstarters mit Kühlluft zur Abfuhr von in dem Motorstarter entstehender Wärme. Aus diesem Grund sind in der Vollwelle quer zu ihrer Längsachse durchgehende Luftkanäle vorgesehen (Fig. 7), die eine Verbesserung der Luftkonvektion bewirken.

In modernen Motorstartern mit leistungsfähiger Elektronik können hohe Ströme auftreten, z. B. Motoranlaufströme von » 50 A für einige Sekunden. Diese periodisch auftretenden Kurzzeitströme, aber auch langzeitige Dauerströme erzeugen eine relativ hohe Verlustwärme. Die Abfuhr einer derart gro-ßen Wärmeleistung aus einem Motorstarter oder - allgemeiner gesprochen - aus einem Schaltgerät kann Probleme bereiten, falls die Luftkonvektion in dem Schaltgerät durch eine voluminöse Vollwelle behindert wird.

Der Erfindung liegt daher die Aufgabe zugrunde, eine mechanische Drehverriegelung eines Schaltgeräts so zu verändern, dass eine erhöhte Wärmeabfuhr aus dem Schaltgerät möglich wird.

Diese Aufgabe wird erfindungsgemäß durch ein Schaltgerät mit den in Anspruch 1 angegebenen Merkmalen und ein Verfahren mit den in Anspruch 10 angegebenen Merkmalen gelöst.

Das erfindungsgemäße Schaltgerät weist ein Gehäuse auf. Das Gehäuse weist eine Frontwand und eine der Frontwand gegenüberliegende Rückwand, eine Deckenwand und eine der Deckenwand gegenüberliegenden Bodenwand, sowie zwei sich gegenüberliegenden Seitenwände auf. Die Frontwand ist die Wand an der Vorderseite des Gehäuses, an der ein Bediener Eingaben machen kann, z.B. Test-Taste, Reset-Taste, und Ausgaben erhält, z.B. LEDs zur Status- und Fehleranzeige. Die Rückwand ist die Wand an der Rückseite des Gehäuses. Die Bodenwand ist die zum Boden hin gerichtete Wand des Gehäuses.

Dabei ist innerhalb des Gehäuses ein parallel zu den Seitenwänden verlaufender Luftkanal ausgebildet. Der Luftkanal weist eine lichte Breite D, gemessen in einer Richtung quer zu den Seitenwänden, auf.

Das erfindungsgemäße Schaltgerät weist eine Drehwelle auf, die sich von der Frontwand durch das Gehäuse zu der Rückwand erstreckt. Die Drehwelle weist einen ersten Endabschnitt auf, der in der Frontwand drehbar gelagert ist. Die Drehwelle weist einen zweiten Endabschnitt auf, der in der Rückwand drehbar gelagert ist. Dabei trägt die Drehwelle am Ende ihres ersten Endabschnitts eine drehfest mit der Drehwelle verbundene Drehvorrichtung, z.B. ein Drehknebel, die an der Außenseite der Frontwand zugänglich ist. Außerdem trägt die Drehwelle am Ende ihres zweiten Endabschnitts eine drehfest mit der Drehwelle verbundene Kupplungsvorrichtung, die an der Außenseite der Rückwand zugänglich ist. Mithilfe der Kupplungsvorrichtung ist das Schaltgerät an einer korrespondierenden Aufnahmevorrichtung befestigbar. Daher wird die Drehwelle auch als "Kupplungswelle" bezeichnet.

Die Bodenwand und die Deckenwand weisen jeweils mindestens eine Lüftungsöffnung auf, so dass in dem Luftkanal ein Luftstrom von der Lüftungsöffnung der Bodenwand zu der Lüftungsöffnung der Deckenwand strömen kann. Die Richtung eines Luftstroms, der durch den Luftkanal streicht, ist von der Bodenwand zur Deckenwand, da der Luftstrom von den wärmeabgebenden Elektronikkomponenten im Inneren des Gehäuses Wärme aufnimmt und daher wärmer als die Umgebung ist: somit steigt die erwärmte Luft des Luftstroms gemäß der natürlichen Konvektion im Luftkanal von unten nach oben auf. Falls die Wärmeabfuhr durch die Konvektion erhöht werden soll, kann auch ein Lüfter eine erzwungene Konvektion durch den Luftkanal hervorrufen. Bei niedrigen Strömen reicht in der Regel eine Wärmeabfuhr über die freie Konvektion aus, bei höheren Strömen wird zusätzlich ein Lüfter verwendet.

Die Drehwelle weist einen zwischen dem ersten Endabschnitt und dem zweiten Endabschnitt liegenden mittleren Abschnitt auf. Der mittlere Abschnitt liegt im Luftkanal und weist einen Außendurchmesser d auf. Dabei ist das Größenverhältnis D/d, d. h. der Quotient des lichten Breite D des Kanals und des Außendurchmesser des im Luftkanal liegenden mittleren Abschnitts der Drehwelle, größer als 1,5. Außerdem ist die Drehwelle als eine Hohlwelle ausgebildet.

Die Aufgabe wird erfindungsgemäß außerdem durch ein Verfahren zur Herstellung einer Drehwelle für ein erfindungsgemäßes Schaltgerät gelöst. Dabei wird ein metallisches Mittelstück als Einlegeteil während eines Einspritzvorganges einer Spritzgussmaschine zugeführt und an beiden Enden des Mittelstücks jeweils ein Kunststoff-Endstück angespritzt.

Der Erfindung liegt die Erkenntnis zugrunde, dass Hohlwellen gegenüber Vollwellen deutliche Vorteile in Bezug auf die Torsionssteifigkeit aufweisen. Das folgende Beispiel von der Webseite https://technikdoku.com/torsion/ (abgerufen am 24.07.2023 15:00 CEST) verdeutlicht das: verglichen werden eine Vollwelle und eine Hohlwelle. Die Vollwelle hat einen Durchmesser von Dm=40 mm (Querschnittsfläche A1=1256 mm²), die Hohlwelle einen Außendurchmesser Dm=70 mm und einen Innendurchmesser dm=57 mm (Querschnittsfläche A2=1297 mm²). Die Querschnittsflächen der beiden Wellen sind also im Wesentlichen identisch (lediglich ein Unterschied von 3 %). Beide Wellen werden jeweils mit einem Torsionsmoment M_t = 700 Nm belastet. Obwohl sich die Querschnittsflächen der Wellen nur unwesentlich unterscheiden, sind die in den Wellen auftretenden Torsionsspannungen τ_t erheblich verschieden: bei der Vollwelle, berechnet mit der Formel τt = (16 M_t)/(π Dm³), beträgt die Torsionsspannung τt = 56 N/mm²; bei der Hohlwelle, berechnet mit der Formel τt = (16 D M_t)/(π (Dm⁴-dm⁴)) beträgt die Torsionsspannung τt = 19 N/mm². Dieses Beispiel veranschaulicht also, dass bei gleichem Gewicht Hohlwellen erheblich größere Torsionsmomente (= Drehmomente) als Vollwellen übertragen können. Oder anders formuliert: Eine Hohlwelle, die mit demselben Torsionsmoment wie eine Vollwelle belastet werden kann, weist einen kleineren Außendurchmesser als die Vollwelle auf.

In der Erfindung nutzt man die Erkenntnis, dass Hohlwellen gegenüber Vollwellen deutliche Vorteile in Bezug auf die Torsionssteifigkeit aufweisen, um in Bezug auf die Drehwelle in eine neue Richtung zu gehen, die sich von der bisherigen Strategie grundsätzlich unterscheidet. Bisher wurde der Durchmesser der als Vollwelle ausgebildeten Drehwelle, möglichst groß gemacht, um eine ausreichend große Torsionssteifigkeit zu erreichen; die durch die voluminöse Drehwelle hervorgerufene Blockade des Luftkanals versuchte man durch Durchgangsöffnungen in der Drehwelle so gut wie möglich zu kompensieren. Gemäß der vorliegenden Erfindung nun verwendet man eine als Hohlwelle ausgebildete Drehwelle und macht den Außendurchmesser der Drehwelle möglichst klein. Dadurch ist es möglich, dass die Hohlwellen-Drehwelle nur einen wesentlich geringeren Bereich des Luftkanals blockiert als mit der herkömmlichen Vollwellen-Drehwelle; zusätzlich wird durch den kleineren Außendurchmesser eine seitliche Umströmung der Drehwelle ermöglicht, d. h. der Luftstrom kann fast ungehindert durch das Steuergerät geleitet werden.

Durch die Verringerung des Durchmessers der Drehwelle v.a. im mittleren Abschnitt der Drehwelle wird Bauraum eingespart, das Schaltgerät kann kleiner gebaut, bzw. es können größere Elektronik-Kühlkörper bei gleichem Bauraum verwendet werden.

Außerdem werden flächige Strömungswiderstände, hier: in Form von Sacklöchern in der herkömmlichen Drehwelle, vermieden. Die Kühlluft kann somit ungehindert an der erfindungsgemäßen Drehwelle außen vorbeiströmen, da der kleinere Außendurchmesser der Drehwelle in Kombination mit der Position der Drehwelle im Schaltgerät so gewählt ist, dass die Drehwelle einen wesentlich kleineren negativen Einfluss auf die Kühlleistung des Kühlkanals hat.

Zur Kopplung des frontseitigen Knebels mit der rückseitigen Montagebasis wird bisher eine als Vollwelle ausgebildete Drehwelle mit großem Durchmesser verwendet, die Lüftungsdurchführungen und Materialfreisparungen in Form von Sacklöchern aufweist. Durch die mittige Lage im Schaltgerät wird die Durchlüftung des schaltgeräts durch die bisherige Drehwelle eingeschränkt. Die Erfindung ersetzt die bisherige Drehwelle durch eine Drehwelle, die rohrartig ausgeführt wird. Dadurch kann die fertigungsbedingte Forderung nach dünnen gleichmäßigen Wandstärken erfüllt werden und zusätzlich wird der Außendurchmesser stark reduziert. Die durch die Torsion der Drehwelle auftretenden mechanischen Spannungen werden trotz der Reduzierung des wirksamen Außendurchmesser ausreichend klein gehalten, indem die Drehwelle als eine Hohlwelle ausgebildet ist.

Durch den geringeren Durchmesser der Drehwelle benötigt man in der Drehwelle keine Materialfreisparungen mehr. Es entsteht eine gleichmäßig glatte, kreisförmige Oberfläche, die strömungstechnisch keine Widerstandsflächen der Luftströmung entgegensetzt. Die Reduzierung des Außendurchmessers bewirkt, dass die Drehwelle hinsichtlich des Strömungswiderstands im Luftkanal keine wesentliche Rolle mehr spielt.

Vorteilhafte Ausgestaltungen und Weiterbildungen der Erfindung sind in den abhängigen Ansprüchen angegeben.

Gemäß einer bevorzugten Ausgestaltung der Erfindung liegt das Verhältnis D/d zwischen 1,8 und 2,2. Dadurch steht die Drehwelle nur in der Hälfte des Luftkanals im Luftstrom; somit wird eine strömungstechnisch sehr gute seitliche Umströmung der Drehwelle ermöglicht.

Gemäß einer bevorzugten Ausgestaltung der Erfindung ist der Luftkanal einerseits durch eine in dem Gehäuse parallel zu einer ersten der zwei Seitenwände angeordnete erste Leiterplatte begrenzt, auf welcher Elektronikbauelemente und Kühlkörper angeordnet sind, und andererseits durch eine parallel zu einer zweiten der zwei Seitenwände angeordnete zweite Platte begrenzt, wobei die lichte Breite D des Luftkanals durch den Abstand zwischen der ersten Leiterplatte und der zweiten Platte definiert ist. Bei höheren Strömen werden Kühlkörper, meist aus Aluminium, verwendet; diese werden wärmeleitend an die Elektronikbauelemente angebunden. Durch die erfindungsgemäße Drehwelle mit reduziertem Außendurchmesser liegen in der Wirklinie "Lufteinlass (Lüfter) => wärmeabgebende Elektronikbauelemente (z.B. Halbleiter) => Kühlkörper => Luftauslass" keine wesentlichen baulichen Strömungswiderstände.

Die Verlustwärme von Elektronikbauelementen muss abgeführt werden, um eine Überhitzung und damit Zerstörung der Elektronikbauelemente zu vermeiden. Das Problem einer ausreichenden Wärmeabfuhr von elektronischen Bauelementen wird vor allem bei einem beengten Bauraum für die elektronischen Bauelemente und bei einem erhöhten Strom, z. B. bei einem Anlaufstrom eines Motors, kritisch. Die im Schaltgerät verbauten Leistungshalbleiter stellen die größte Wärmequelle dar. Die Temperaturentwicklung, die im Dauerbetrieb bzw. im Motoranlaufbetrieb entsteht, ist maßgeblich für die weitere Auslegung von elektronischen und mechanischen Bauteilen sowie für die Klassifizierung der Einsatzbedingungen (Nennstrom, Anlaufstrom, zulässige Umgebungstemperatur, ...).

Das erfindungsgemäße Schaltgerät weist mindestens ein Elektronikbauelemente auf. Unter einem Bauelement in der Elektrotechnik und der Elektronik, kurz: Elektronikbauelement, versteht man die kleinste, nicht weiter zerlegbare Einheit in einem Schaltkreis (DIN 40150:1979-10 Begriffe zur Ordnung von Funktions- und Baueinheiten), z. B. einen Widerstand. Ein Elektronikbauelement kann ein passives Elektronikbauelement sein, wie z.B. ein Widerstand, eine Spule oder ein Kondensator. Ein Elektronikbauelement kann außerdem ein aktives Elektronikbauelement sein, wie z.B. ein Transistor (IGBT, FET, MOSFET, etc.), eine Diode, ein Gleichrichter, ein Prozessor / IC (= Integrated Circuit), eine LED. Ein Elektronikbauelement kann auch ein Bauelement der Leistungselektronik sein. Elektronikbauelemente können z. B. Diacs, Triacs, Transistoren, MOSFETs, IGBTs, Thyristoren, Dioden, Kondensatoren, etc. in der Leistungselektronik sein, ebenso Bauelemente in der Steuerelektronik wie Controller, Spannungsregler, Widerstände, Spulen, etc. Ein Elektronikbauelement kann insbesondere ein Leistungshalbleiter bzw. ein Leistungshalbleiter-Modul sein.

Gemäß einer bevorzugten Ausgestaltung der Erfindung ist die zweite Platte eine Isolierplatte, welche die erste Leiterplatte elektrisch von einer zweiten Leiterplatte, welche zwischen der zweiten Platte und der zweiten Seitenwand angeordnet ist, isoliert.

Gemäß einer bevorzugten Ausgestaltung der Erfindung liegt eine Wandstärke der als Hohlwelle ausgebildeten Drehwelle in einem Wertebereich von 0,5 bis 5 mm, weiter bevorzugt in einem Wertebereich von 1 bis 4 mm, noch weiter bevorzugt in einem Wertebereich von 2 bis 3 mm.

Gemäß einer bevorzugten Ausgestaltung der Erfindung ist die Drehwelle axial aus zwei oder mehr Einzelteilen zusammengesetzt. Man teilt die Drehwelle in zwei oder mehr Einzelteile, vorzugsweise aus Kunststoff, auf. Über Wechseleinsätze in einem Herstellungswerkzeug, z.B. einem Spritzwerkzeug, kann man mit relativ geringem Aufwand verschiedene Varianten der Drehwelle mit unterschiedlichen Längen herstellen. Somit kann man den Wunsch nach Variabilität bezüglich der Länge der Drehwelle erfüllen.

Gemäß einer bevorzugten Ausgestaltung der Erfindung ist die Drehwelle aus zwei oder mehr Einzelteilen zusammengesetzt ist, die miteinander verschnappt werden.

Gemäß einer bevorzugten Ausgestaltung der Erfindung ist die Drehwelle aus einem metallischen Mittelstück und zwei Kunststoff-Endstücken zusammengesetzt. Man teilt die Drehwelle in drei oder mehr Einzelteile auf, wobei zwei Endstücke aus Kunststoff und mittig ein Mittelstück aus Stahl besteht. Die Längenvariabilität kann durch verschiedene Längen des Mittelstücks gesteuert werden. Dieses Metall-Mittelstück nimmt den größten Teil der Torsionsspannung auf.

Gemäß einer bevorzugten Ausgestaltung der Erfindung ist das Mittelstück ein Rundstahl mit gezahnten Enden. Das Mittelstück kann aus einem Rundstahl mit gezahnten Enden gestaltet sein, so dass es fest und verdrehsicher mit den Endstücken verpresst werden kann.

Gemäß einer bevorzugten Ausgestaltung der Erfindung ist das Mittelstück als ein Vierkant-Stab gestaltet, der lose in die Endstücke gesteckt wird.

Gemäß einer bevorzugten Ausgestaltung der Erfindung wird das Metallteil beim Spritzvorgang in das Spritzwerkzeug eingelegt und umspritzt; es entsteht ein Metall-Kunststoff-Hybridteil.

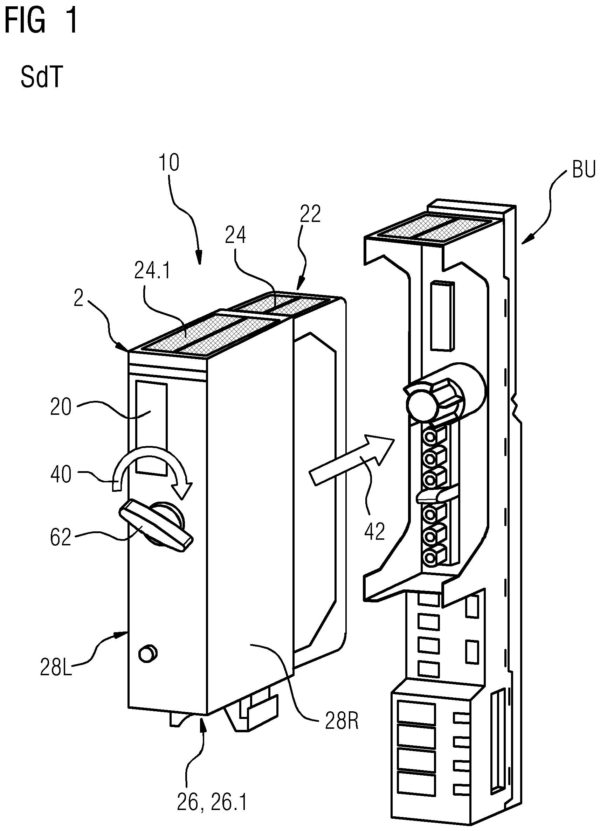

Im Folgenden wird die Erfindung unter Zuhilfenahme der beiliegenden Zeichnung erläutert. Es zeigt jeweils schematisch und nicht maßstabsgetreu
- Fig. 1: einen ersten Schritt zur Montage eines herkömmlichen Motorstarters auf einer Montagebasis;

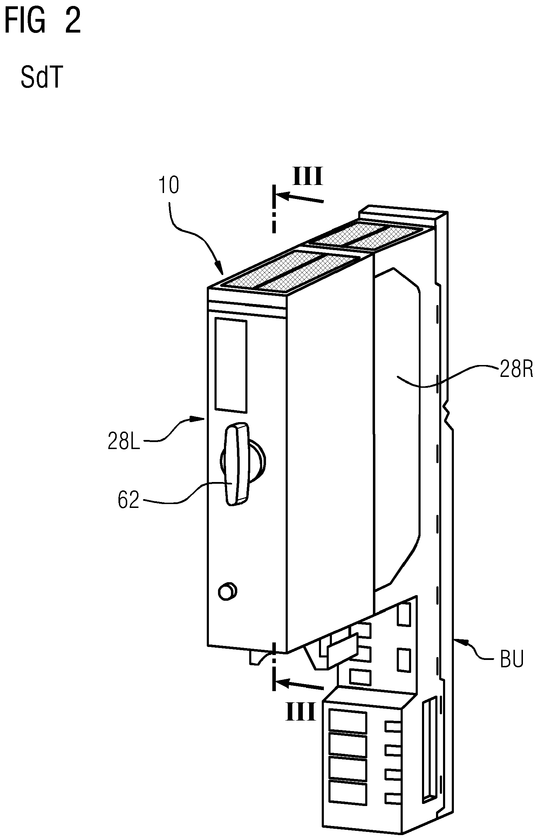

- Fig. 2: einen zweiten Schritt zur Montage eines herkömmlichen Motorstarters auf einer Montagebasis;

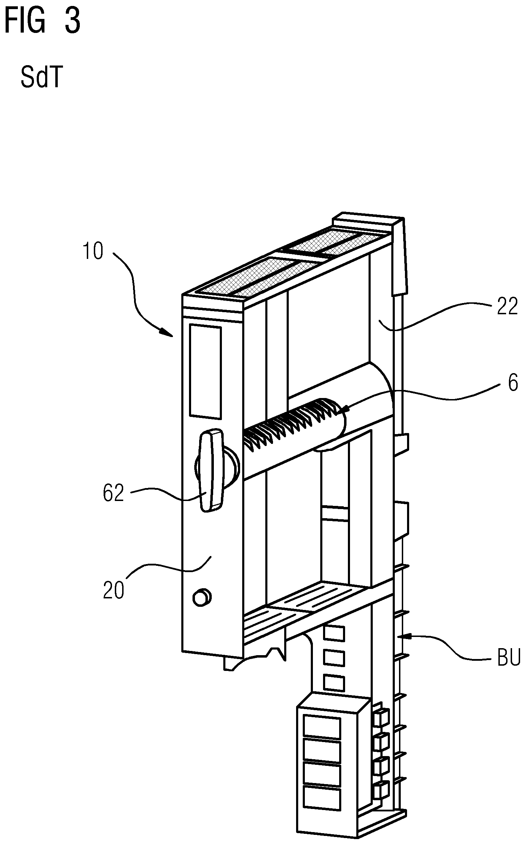

- Fig. 3: einen Schnitt eines auf einer Montagebasis montierten herkömmlichen Motorstarters;

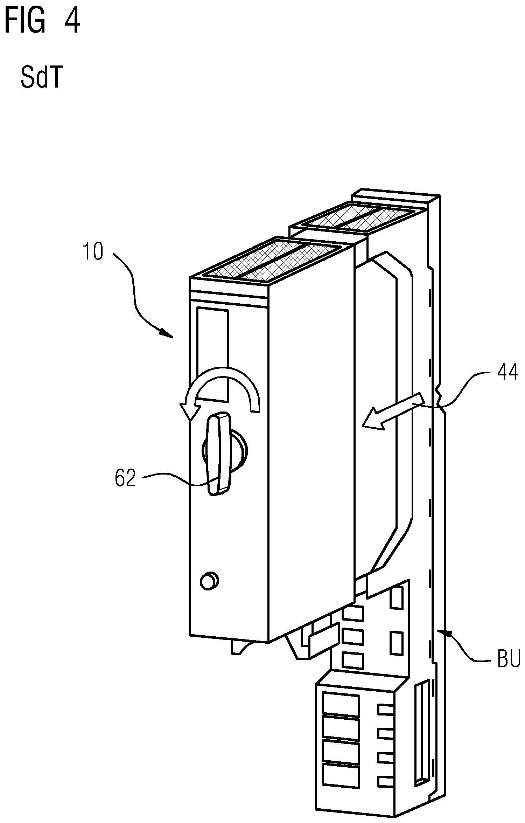

- Fig. 4: einen Schritt zur Demontage eines herkömmlichen Motorstarters von einer Montagebasis;
- Fig. 5: eine herkömmliche Drehwelle;
- Fig. 6: einen Schnitt eines herkömmlichen Motorstarters parallel zu den Seitenwänden;
- Fig. 7: einen Schnitt A-A und einen Schnitt B-B eines herkömmlichen Motorstarters parallel zu der Frontwand;

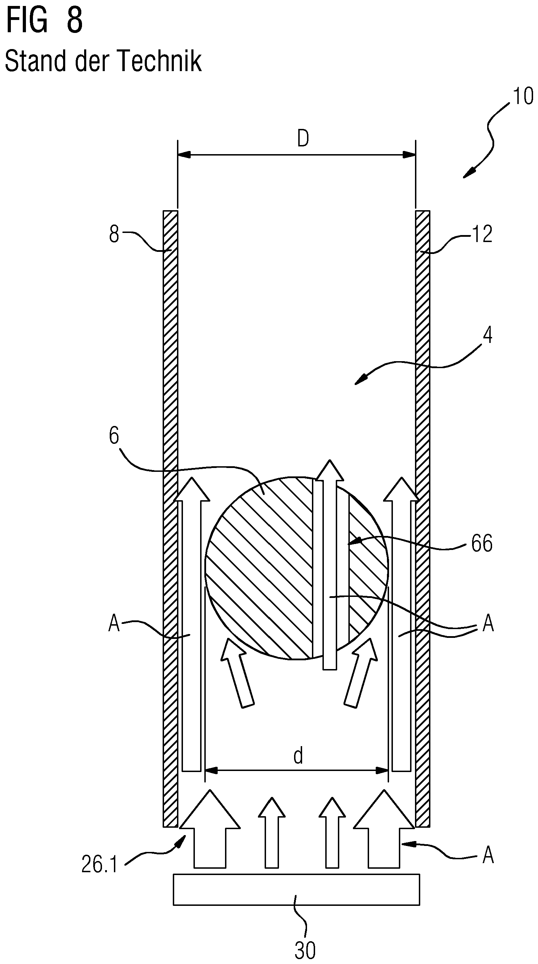

- Fig. 8: einen Schnitt eines herkömmlichen Schaltgeräts parallel zu der Frontwand;

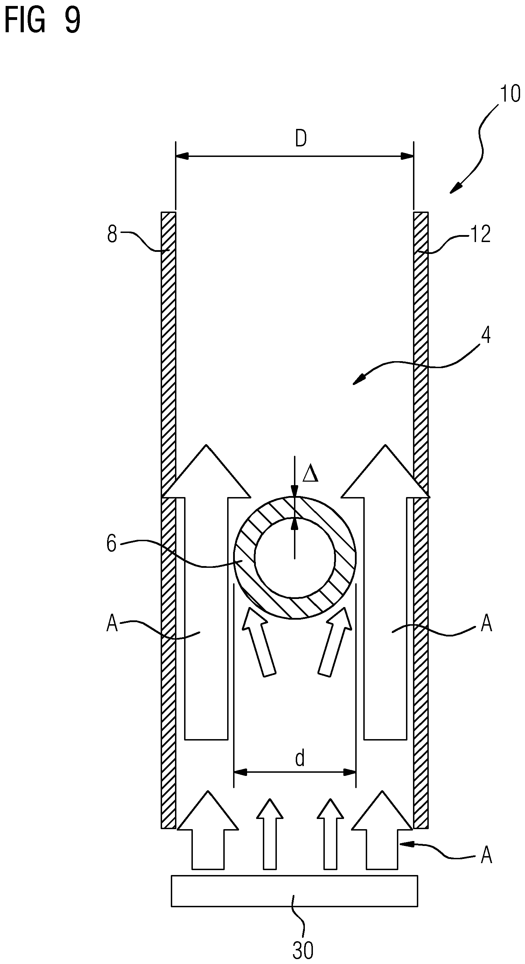

- Fig. 9: einen ersten Schnitt eines erfindungsgemäßen Schaltgeräts parallel zu der Frontwand;

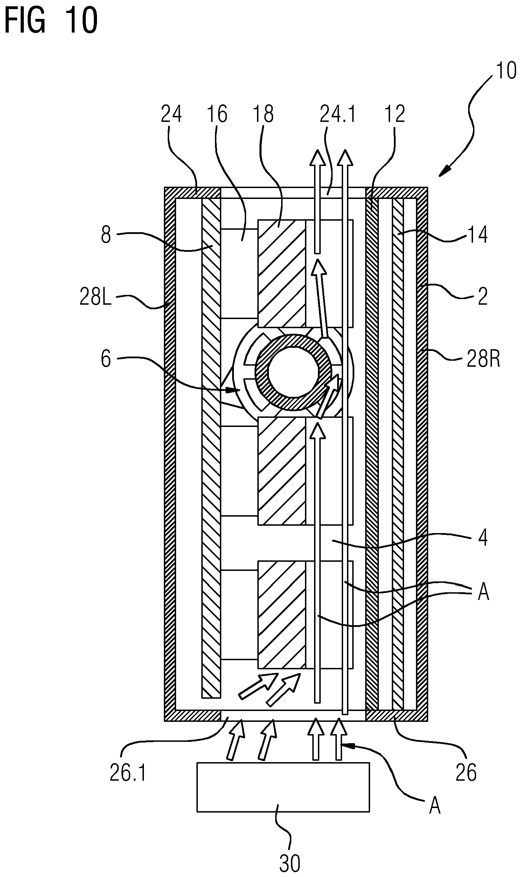

- Fig. 10: einen zweiten Schnitt eines erfindungsgemäßen Schaltgeräts parallel zu der Frontwand;

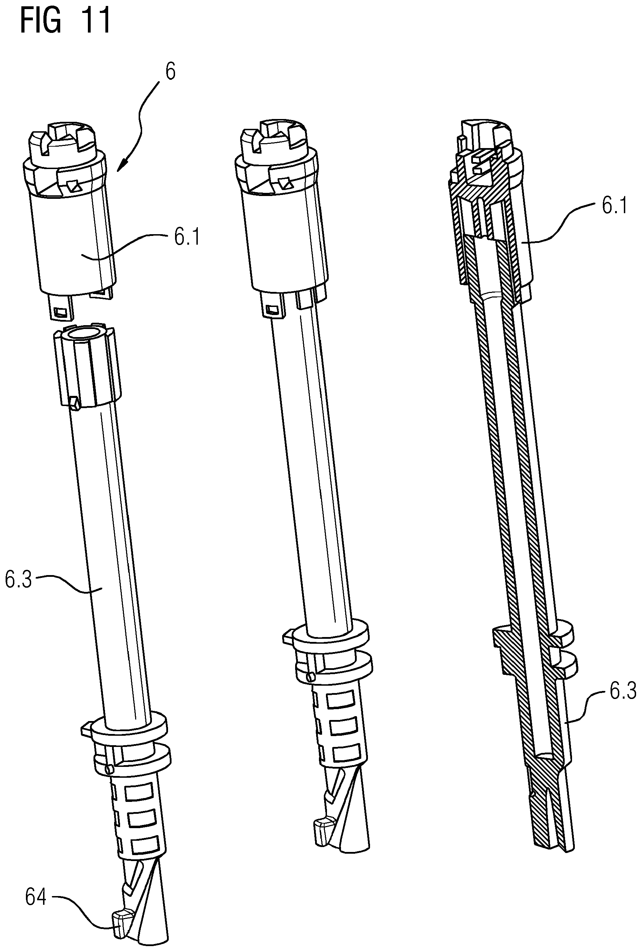

- Fig. 11: drei Ansichten einer zweiteiligen Drehwelle eines erfindungsgemäßen Schaltgeräts; und

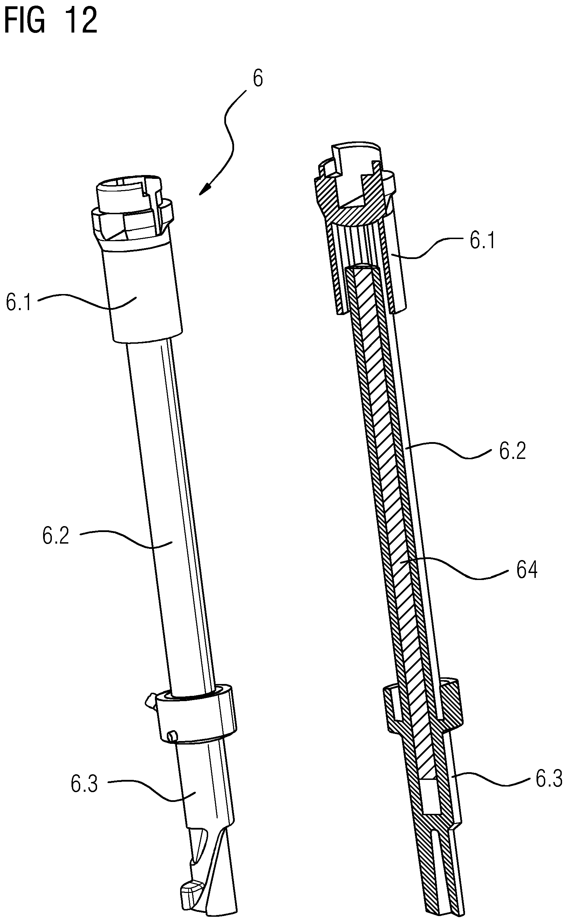

- Fig. 12: zwei Ansichten einer dreiteiligen Drehwelle eines erfindungsgemäßen Schaltgeräts.

Fig. 1 bis 4 zeigen ein herkömmliches Schaltgerät, nämlich einen SIMATIC ET 200SP Motorstarter, der auf eine korrespondierende, vollverdrahtete Montagebasis montiert wird, wie in der Beschreibungseinleitung angegeben.

Das Schaltgerät 10 weist ein Gehäuse 2 mit einer Frontwand 20, einer der Frontwand 20 gegenüberliegenden Rückwand 22, einer Deckenwand 24 und einer der Deckenwand 24 gegenüberliegenden Bodenwand 26, und zwei sich gegenüberliegenden Seitenwänden 28L, 28R auf. In dem Gehäuse 2 ist ein parallel zu den Seitenwänden 28L, 28R verlaufender Luftkanal 4 ausgebildet, der eine lichte Breite D, gemessen in einer Richtung quer zu den Seitenwänden 28L, 28R, aufweist. Dabei weisen die Deckenwand 24 und die Bodenwand 26 jeweils Lüftungsöffnungen 24.1, 26.1 auf.

Das Schaltgerät 10 weist eine Drehwelle 6 auf, die in der Frontwand 20 drehbar gelagert ist und an ihrem über die Frontwand 20 aus dem Gehäuse 2 hinausstehenden Ende eine drehfest mit der Drehwelle 6 verbundene Drehvorrichtung 62 trägt. Diese Drehvorrichtung 62, die in dem vorliegenden Ausführungsbeispiel als ein Drehknebel ausgestaltet ist, ist einem Bediener des Schaltgeräts 10, der den Motorstarter 10 auf einer korrespondierenden Montagebasis montieren möchte, von der Außenseite der Frontwand 20 her zugänglich. Die Drehwelle 6 ist außerdem in der Rückwand 22 drehbar gelagert und trägt an ihrem über die Rückwand 22 aus dem Gehäuse 2 hinausstehenden Ende eine drehfest mit der Drehwelle 6 verbundene Kupplungsvorrichtung 64. Mithilfe der Kupplungsvorrichtung 64 ist das Gehäuse 2 des Schaltgeräts 10 an einer korrespondierenden Aufnahmevorrichtung BU, auch als: Montagebasis bezeichnet, befestigbar ist.

Fig. 1 zeigt einen ersten Schritt zur Montage des Motorstarters 10 auf der Montagebasis BU. Zunächst wird die Drehwelle 6 des Motorstarters 10 mittels des Drehknebels 62 der Drehwelle 6 in eine Montage-/ Demontageposition gedreht, wie mit dem Pfeil 40 angedeutet. Danach wird der Motorstarter 10 auf die Montagebasis BU geführt, wie mit dem Pfeil 42 angedeutet.

Fig. 2 zeigt einen zweiten Schritt, in dem die Drehwelle 6 des Motorstarters 10 in die Betriebsposition/READY gebracht wurde: in dieser Position ist der Motorstarter 10 fest in der Montagebasis BU verriegelt und alle elektrischen Kontakte sind verbunden.

Fig. 3 zeigt den in Fig. 2 angegebenen Schnitt III-III parallel zu den Seitenwänden 28L, 28R.: im Inneren des Gehäuses 10 ist die Drehwelle 6 zu sehen, die zur Verriegelung des Motorstarters 10 in der Montagebasis BU dient.

Fig. 4 zeigt einen Demontageschritt, in dem der Motorstarter 10 wieder von der Montagebasis BU abgenommen wird, wie mit dem Pfeil 44 angedeutet. Dazu wird die Drehwelle 6 des Motorstarters 10 zurück in die Montage-/ Demontageposition gedreht, wodurch der Motorstarter 10 aus der Montagebasis BU herausgedrückt wird, und danach der Motorstarter 10 von der Montagebasis BU abgezogen. Bei der Drehung der Drehwelle, durch Betätigung des Drehknebels, kann ein Drehmoment von zeitweise bis zu 2 Nm auf die Drehwelle wirken, das zu mechanischen Spannungen in der Drehwelle führt.

Fig. 5 zeigt eine herkömmliche Drehwelle 6. Die Drehwelle 6 weist einen ersten Endabschnitt 6F auf, der in der Frontwand 20 eines Motorstarters 10 drehbar gelagert werden kann. Die Drehwelle 6 weist einen zweiten Endabschnitt 6R auf, der in der Rückwand 22 eines Motorstarters 10 drehbar gelagert werden kann. Dabei kann die Drehwelle 6 am Ende ihres ersten Endabschnitts 6F eine drehfest mit der Drehwelle 6 verbundene Drehvorrichtung 62 tragen, die an der Außenseite der Frontwand 20 einem Bediener des Schaltgeräts 10 zugänglich ist. Die Drehvorrichtung 62 kann als ein Drehknebel ausgebildet sein.

Und die Drehwelle 6 kann am Ende ihres zweiten Endabschnitts 6R eine drehfest mit der Drehwelle 6 verbundene Kupplungsvorrichtung 64 tragen, mithilfe der das Schaltgerät 10 an einer korrespondierenden Aufnahmevorrichtung BU befestigbar ist. Dabei kann die Kupplungsvorrichtung 64 als eine Haltenase ausgebildet sein, die in der Art eines Bajonettverschlusses in eine korrespondierende Nutenbahn in der Montagebasis einrasten kann.

Die Drehwelle 6 weist einen zwischen dem ersten 6F und dem zweiten 6R Endabschnitt liegenden mittleren Abschnitt 6M auf, der einem Außendurchmesser d aufweist. Dieser mittlere Abschnitt 6M liegt, wenn die Drehwelle 6 in das Gehäuse 2 des Schaltgeräts 10 montiert ist, in dem Luftkanal 4 des Schaltgeräts 10. B

Bei der Betätigung der Drehvorrichtung 62, z.B. des Drehknebels, können Drehmomente von zeitweise bis zu 2Nm auftreten, die zu mechanischen Spannungen in der Drehwelle 6 führen. Die Drehwelle 6 muss so ausgelegt sein, dass es zu keiner Beschädigung während der Betätigung kommt.

Durch den relativ großen Abstand zwischen Frontwand und Rückwand der Grundeinheit von > 10cm ergibt sich eine Torsion der Drehwelle. Diese Torsion sollte möglichst klein gehalten werden, um die Funktionssicherheit zu gewährleisten.

Die Drehwelle darf nicht elektrisch leitend sein und muss an den Enden Funktionsflächen/ -konturen (Bajonettverschluss-Haltenase an der Welle, die in eine korrespondierende Nutenbahn in der Montagebasis einrastet, Mitnehmerzapfen, Verrastungen, etc.) aufweisen. Somit bietet sich Kunststoff als Material an.

Folgende Charakteristika der herkömmlichen Drehwellen ergeben sich bauartbedingt: Um die Festigkeit und Verdrehsteifigkeit zu gewährleisten, weisen herkömmliche Drehwellen wegen der Länge (>10cm) einen möglichst großen Durchmesser auf. Die Drehwellen mit ihrem relativ großen Durchmesser versperren aber den Kühlkanal und verhindern eine gute Durchströmung des Gehäuses mit Kühlluft.

Zur Verbesserung der Durchströmung des Gehäuses mit Kühlluft weist die Drehwelle 6 durchgehende Öffnungen 66 auf. Jedoch verschlechtern diese durchgehenden Öffnungen 66 die Torsionssteifigkeit der Drehwelle 6, da sie ideale Zylinderkontur sehr stark schwächen. Diese Schwächung wird kompensiert durch eine weitere Vergrößerung des Durchmessers der Drehwelle 6, so dass der für eine kühlende Luftströmung durch den Luftkanal verfügbare Raum stark eingeschränkt wird, siehe Fig. 7.

Außer den durchgehenden Öffnungen 66 weist die herkömmliche Drehwelle 6 auch Sacklöcher 68 auf: diese Aussparungen dienen zur Verringerung der Materialstärke. Dadurch wird versucht die Zykluszeit beim Kunststoffspritzen der Drehwelle 6 möglichst kurz zu halten. Die durchgehenden Öffnungen 66 können immer nur im Wechsel mit Sacklöchern 68 ausgeführt werden, was wiederum eine sehr starke Einschränkung der Luftströmung durch den Luftkanal bewirkt.

Fig. 5 zeigt außer der senkrechten Ansicht der Drehwelle 6 (links) auch eine Schrägansicht der Drehwelle 6 (rechts) sowie zwei Schnitte der Drehwelle 6 quer zu ihrer Längsachse: einen Schnitt A-A und einen Schnitt B-B, deren Lage in der senkrechten Ansicht der Drehwelle 6 angegeben sind.

Fig. 6 und 7 zeigen Schnitte eines herkömmlichen Motorstarters. Der in Fig. 6 gezeigte Schnitt verläuft parallel zu den Seitenwänden. Die in Fig. 7 gezeigten Schnitte verlaufen parallel zu der Frontwand. Dabei ist der Luftkanal 4 einerseits durch eine in dem Gehäuse parallel zu einer ersten 28L der zwei Seitenwände 28L, 28R angeordnete erste Leiterplatte 8 begrenzt, auf welcher Elektronikbauelemente 16, z.B. Leistungshalbleiter, und auf den Elektronikbauelementen 16 angeordnete Kühlkörper 18 angeordnet sind. Andererseits ist der Luftkanal 4 durch eine parallel zu einer zweiten 28R der zwei Seitenwände 28L, 28R angeordnete zweite Platte 12 begrenzt. Dabei ist die zweite Platte 12 eine Isolierplatte, welche die erste Leiterplatte 8 elektrisch von einer zweiten Leiterplatte 14, welche zwischen der zweite Platte 12 und der zweiten Seitenwand 28R angeordnet ist, isoliert. Dabei wird die lichte Breite D des Luftkanals 4 durch den Abstand zwischen der ersten Leiterplatte 8 und der zweiten Platte 12 definiert.

Bei der Nutzung von Thyristoren reicht bis zu einem gewissen Anlaufstrom (z. B. 50 A für 6 s) die Entwärmung der Thyristoren über die erste Leiterplatte aus (Leiterplattenkühlung). Die Wärmeleistung im Dauerstrom wird z.B. über gebypasste niederohmige Relais begrenzt. Dadurch kann auf zusätzliche Kühlkörper verzichtet werden. Somit steht im Inneren des Gehäuses ausreichend Platz für eine Drehwelle mit einem großen Durchmesser und großen durchgehenden Öffnungen 66 zur Verfügung, siehe Fig. 6.

Es steht somit im Inneren des Gehäuses ausreichend Platz für eine Drehwelle mit einem großen Durchmesser und großen durchgehenden Öffnungen 66 zur Verfügung, da keine weiteren großvolumigen Kühlkörper benötigt werden, siehe Fig. 6.

Man versucht also, einen möglichst großen Durchmesser d der Drehwelle 6 zu erreichen, die mit möglichst großen durchgehenden Öffnungen 66 ausgestattet ist. Das bedeutet wiederum, dass die Drehwelle vollständig im Luftstrom A steht, der Luftstrom aber nur durch die durchgehenden Öffnungen 66 der Drehwelle hindurch auf die gegenüberliegende Seite der Drehwelle gelangen kann. Fertigungsbedingt wechseln sich die durchgehenden Öffnungen 66 mit den Sacklöchern 68 ab, was zu völlig unterschiedlichen Strömungsverhalten führt, wie man an den Schnitten der Fig. 7 sieht. Fig. 7 zeigt links einen Schnitt in der Ebene A-A der Drehwelle gemäß Fig. 5 und rechts einen Schnitt in der Ebene B-B der Drehwelle gemäß Fig. 5. Der linke Schnitt zeigt eine Drehstellung der Drehwelle 6, in der ein relativ kleiner Luftstrom durch die Drehwelle 6 strömen kann. Der rechte Schnitt zeigt eine Drehstellung der Drehwelle 6, in der der Luftstrom durch die Drehwelle 6 vollständig abgeblockt wird.

Die großvolumige Drehwelle schränkt weiterhin den zur Verfügung stehenden Bauraum ein. Die Möglichkeit, Kühlkörper zu verwenden, wird extrem eingeschränkt.

Bei niedrigen Strömen mit geringer Wärmefreisetzung reicht eine Wärmeabfuhr über die freie Konvektion aus, bei höheren Strömen mit erhöhter Wärmefreisetzung wird zusätzlich ein Lüfter 30 verwendet, der eine erzwungene Konvektion hervorruft.

Fig. 8 zeigt einen Schnitt eines herkömmlichen Schaltgeräts 10 parallel zu der Frontwand des Gehäuses des Motorstarters 10. Dabei wird die lichte Breite D des Luftkanals 4 durch den Abstand zwischen der ersten Leiterplatte 8 und der zweiten Platte 12 definiert. Inmitten des Luftkanals 4 erstreckt sich eine als Vollwelle ausgestaltete Drehwelle 6 mit einem Außendurchmesser d. Das Verhältnis D/d ist circa 1,3. Die Drehwelle 6 weist ein oder mehrere durchgehende Öffnungen 66 auf, durch die ein Teil des durch eine Lüftungsöffnung 26.1 der Bodenwand eintretenden Luftstroms A, angetrieben durch einen Lüfter 30, strömen kann. Ein anderer Teil dieses Luftstroms A streicht zwischen den Außenseiten der Drehwelle 6 und den den Luftkanal 4 begrenzenden Wänden 8, 12 hindurch. Insgesamt wird ein relativ großer Teil des Luftstroms A durch die Drehwelle 6 abgeblockt.

Fig. 9 zeigt einen ersten Schnitt eines erfindungsgemäßen Schaltgeräts 10 parallel zu der Frontwand des Gehäuses des Motorstarters 10. Dabei wird die lichte Breite D des Luftkanals 4 durch den Abstand zwischen der ersten Leiterplatte 8 und der zweiten Platte 12 definiert. Inmitten des Luftkanals 4 erstreckt sich eine als Hohlwelle ausgestaltete Drehwelle 6 mit einem Außendurchmesser d, der wesentlich kleiner als der Außendurchmesser D der in Fig. 8 gezeigten herkömmlichen Drehwelle ist. Das Verhältnis D/d ist circa 2. Ein wesentlicher Teil, ca. 50 %, eines Luftstroms A, der durch eine Lüftungsöffnung 26.1 der Bodenwand, angetrieben durch einen Lüfter 30, in den Luftkanal 4 eintritt, kann zwischen den Außenseiten der Drehwelle 6 und den den Luftkanal 4 begrenzenden Wänden 8, 12 hindurch streichen. Insgesamt wird ein relativ geringer Teil des Luftstroms A durch die Drehwelle 6 abgeblockt.

Fig. 10 zeigt einen zweiten Schnitt eines erfindungsgemäßen Schaltgeräts 10 parallel zu der Frontwand. Das Schaltgerät 10 weist ein Gehäuse 2 mit einer Deckenwand 24 und einer der Deckenwand 24 gegenüberliegenden Bodenwand 26, und zwei sich gegenüberliegenden Seitenwänden 28L, 28R auf. Dabei weisen die Deckenwand 24 und die Bodenwand 26 jeweils Lüftungsöffnungen 24.1, 26.1 auf, durch die ein von einem Lüfter 30 erzeugter Luftstrom A ein- bzw. austreten kann. In dem Gehäuse 2 ist ein parallel zu den Seitenwänden 28L, 28R verlaufender Luftkanal 4 ausgebildet, der eine lichte Breite D, gemessen in einer Richtung quer zu den Seitenwänden 28L, 28R, aufweist.

Der Luftkanal 4 ist einerseits durch eine in dem Gehäuse parallel zu einer ersten 28L der zwei Seitenwände 28L, 28R angeordnete erste Leiterplatte 8 begrenzt, auf welcher Elektronikbauelemente 16 und Kühlkörper 18 angeordnet sind, und andererseits durch eine parallel zu einer zweiten 28R der zwei Seitenwände 28L, 28R angeordnete zweite Platte 12 begrenzt, wobei die lichte Breite D des Luftkanals 4 durch den Abstand zwischen der ersten Leiterplatte 8 und der zweiten Platte 12 definiert ist. Die zweite Platte 12 ist eine Isolierplatte ist, welche die erste Leiterplatte elektrisch von einer zweiten Leiterplatte, welche zwischen der zweiten Platte und der zweiten Seitenwand angeordnet ist, isoliert.

Das Schaltgerät 10 weist eine Drehwelle 6 auf, die in der Frontwand 20 drehbar gelagert ist. Die Drehwelle 6 ist außerdem in der Rückwand 22 drehbar gelagert.

Fig. 11 zeigt drei Ansichten einer zweiteiligen Drehwelle 6 eines erfindungsgemäßen Schaltgeräts. Die Drehwelle 6 ist in zwei als Hohlwellen ausgebildete Einzelteile 6.1, 6.2 aus Kunststoff aufgeteilt. Über Wechseleinsätze im Spritzwerkzeug kann man mit relativ geringem Aufwand verschiedene Varianten mit unterschiedlicher Länge realisieren. Somit kann man den Wunsch nach Variabilität bzgl. Länge erfüllen.

Fig. 12 zeigt zwei Ansichten einer dreiteiligen Drehwelle 6 eines erfindungsgemäßen Schaltgeräts. Die Drehwelle 6 ist in drei Einzelteile 6.1, 6.2, 6.3 aufgeteilt: Zwei Endstücke 6.1, 6.3 aus Kunststoff und mittig ein Zwischenstück 6.2 aus einem Kunststoff-Metall-Hybrid-Teil (= Verbundwerkstoff = Compound). Dabei wird das Zwischenstück auch als Mittelstück bezeichnet. Dabei wird das Metall-Zwischenstück 6.2 als ein Einlegeteil während des Einspritzvorganges der Spritzgussmaschine zugeführt.

In einer weiteren Ausführung wird ein Zwischenstück 6.2 aus Stahl verwendet. Das Zwischenstück 6.2 kann z.B. aus einem Rundstahl mit gezahnten Enden gestaltet sein, so dass es fest und verdrehsicher mit den Endstücken verpresst ist. Oder aber das Zwischenstück 6.2 kann als ein Vierkant-Stahlstift gestaltet sein, das lose in die Endstücke 6.1, 6.3 gesteckt wird. Die Längenvariabilität kann durch verschiedene Längen des Zwischenstücks 6.2 gesteuert werden.

Es ist möglich, dass das Zwischenstück 6.2 einen von einem Kunststoffmantel umhüllten Metallstift 6.4 aufweist.

## Patentansprüche

1. Schaltgerät (10), aufweisend
- ein Gehäuse (2) mit einer Frontwand (20), einer der Frontwand gegenüberliegenden Rückwand (22), einer Deckenwand (24) und einer der Deckenwand (24) gegenüberliegenden Bodenwand (26), und zwei sich gegenüberliegenden Seitenwänden (28L, 28R), wobei in dem Gehäuse (2) ein parallel zu den Seitenwänden (28L, 28R) verlaufender Luftkanal (4) ausgebildet ist, der eine lichte Breite D, gemessen in einer Richtung quer zu den Seitenwänden (28L, 28R), aufweist,
- eine Drehwelle (6), die sich von der Frontwand (20) durch das Gehäuse zu der Rückwand (22) erstreckt und mit einem ersten Endabschnitt (6F) in der Frontwand (20) und mit einem zweiten Endabschnitt (6R) in der Rückwand (22) drehbar gelagert ist, wobei die Drehwelle (6) am Ende ihres ersten Endabschnitts (6F) eine drehfest mit der Drehwelle (6) verbundene Drehvorrichtung (62) trägt, die an der Außenseite der Frontwand (20) zugänglich ist, und wobei die Drehwelle (6) am Ende ihres zweiten Endabschnitts (6R) eine drehfest mit der Drehwelle verbundene Kupplungsvorrichtung (64) trägt, mithilfe der das Schaltgerät an einer korrespondierenden Aufnahmevorrichtung (BU) befestigbar ist,
- wobei die Bodenwand (26) und die Deckenwand (24) jeweils mindestens eine Lüftungsöffnung (26.1, 24.1) aufweisen, so dass in dem Luftkanal (4) ein Luftstrom (A) von der Lüftungsöffnung (26.1) der Bodenwand (26) zu der Lüftungsöffnung (24.1) der Deckenwand (24) strömen kann,
- wobei die Drehwelle (6) einen zwischen dem ersten (6F) und dem zweiten (6R) Endabschnitt liegenden mittleren Abschnitt (6M) mit einem Außendurchmesser d aufweist, der im Luftkanal (4) liegt und
**dadurch gekennzeichnet,**
**dass** die Drehwelle als eine Hohlwelle ausgebildet ist und das Verhältnis D/d größer als 1,5 ist.

2. Schaltgerät (10) nach Anspruch 1, wobei das Verhältnis D/d zwischen 1,8 und 2,2 liegt.

3. Schaltgerät nach einem der vorhergehenden Ansprüche, wobei der Luftkanal einerseits durch eine in dem Gehäuse parallel zu einer ersten (28L) der zwei Seitenwände (28L, 28R) angeordnete erste Leiterplatte (8) begrenzt ist, auf welcher Elektronikbauelemente (16) und Kühlkörper (18) angeordnet sind, und andererseits durch eine parallel zu einer zweiten (28R) der zwei Seitenwände (28L, 28R) angeordnete zweite Platte (12) begrenzt ist, wobei die lichte Breite D des Luftkanals (4) durch den Abstand zwischen der ersten Leiterplatte (8) und der zweiten Platte (12) definiert ist.

4. Schaltgerät nach Anspruch 3, wobei die zweite Platte (12) eine Isolierplatte ist, welche die erste Leiterplatte elektrisch von einer zweiten Leiterplatte, welche zwischen der zweiten Platte und der zweiten Seitenwand angeordnet ist, isoliert.

5. Schaltgerät nach einem der vorhergehenden Ansprüche, wobei eine Wandstärke (Δ) der Drehwelle in einem Wertebereich von 2 bis 3 mm liegt.

6. Schaltgerät nach einem der vorhergehenden Ansprüche, wobei die Drehwelle (6) axial aus zwei oder mehr Einzelteilen (6.1, 6.2, 6.3) zusammengesetzt ist.

7. Schaltgerät nach einem der vorhergehenden Ansprüche, wobei die Drehwelle aus zwei oder mehr Einzelteilen (6.1, 6.2, 6.3) zusammengesetzt ist, die miteinander verschnappt werden.

8. Schaltgerät nach einem der vorhergehenden Ansprüche, wobei die Drehwelle aus einem metallischen Mittelstück (6.2) und zwei Kunststoff-Endstücken (6.1, 6.3) zusammengesetzt ist.

9. Schaltgerät nach Anspruch 8, wobei das Mittelstück (6.2) ein Rundstahl mit gezahnten Enden ist.

10. Verfahren zur Herstellung einer Drehwelle für ein Schaltgerät (10) gemäß einem der vorhergehenden Ansprüche, wobei das metallische Mittelstück als Einlegeteil während eines Einspritzvorganges einer Spritzgussmaschine zugeführt wird und an beiden Enden des Mittelstücks jeweils ein Kunststoff-Endstück angespritzt wird.
